# EUROPEAN PATENT APPLICATION

(11) **EP 4 831 649 A1**
(43) Date of publication of application: **28.10.2026**
(21) Application number: 25171650.2
(22) Date of filing: 22.04.2025
(51) Int. Cl.: G01R 15/06, G01R 15/14, G01R 15/16, G01R 19/155, H01R 13/53, H01R 13/66

(54) **INSULATION PLUG**

(71) Applicant: 3M Innovative Properties Co., St. Paul, MN 55133-3427 (US)
(72) Inventor: Stollwerck, Gunther, 47802 Krefeld (DE); Gunjaca, Mirco, 48301 Nottuln (DE); Ahlmann, Willy A., 47447 Moers (DE); Pesch, Marc C., 42781 Haan (DE); Howard, Patrick C., Austin, TX, 78753 (US)
(74) Representative: Müller, Bruno

(57) **Abstract**

Sensored insulation plug (1) for a medium-voltage or high-voltage separable connector, operable to detect the elevated voltage. The insulation plug comprises a) a plug body (140), b) a detection electrode (171) embedded in the plug body (140) and held on a detection voltage when the separable connector is on high or medium voltage, and c) a conductive torque feature (250) for threading the sensored insulation plug (1) into the separable connector.

The torque feature (250) comprises a detection contact (270) to facilitate picking up the detection voltage, conductively connected with the detection electrode (171) via a conductive element (240).

The conductive element (240) is elastically compressible and has a spring constant of less than 2000 Newton/meter for its axial elastic compression.

## Description

This disclosure relates to insulation plugs for separable connectors in medium-voltage and high-voltage power distribution networks. In particular, it relates to such plugs that have a voltage detection feature. The disclosure also relates to power distribution networks with separable connectors having such insulation plugs installed therein and to methods of installing such insulation plugs.

Power distribution networks transmitting electrical power in large geographic areas, such as national grids, are becoming more complex to operate because nowadays consumers can generate energy on their premises and feed it into these networks in a decentralized manner, at unpredictable times and in unpredictable amounts. Network operators place voltage sensing devices in electrical installations at key locations of their network, such as in switchgears or transformers to collect information about the current state of their power network.

In a medium-voltage or high-voltage power distribution network, a power cable is typically connected to network apparatus, such as switchgears or transformers, by a separable connector, also often referred to as a removable power connector, mounted at the end of the cable. T-body connectors and elbow connectors are examples of such separable connectors. Such separable connectors have a front cavity to receive a protruding portion of a bushing of the apparatus, and a connection element on high or medium voltage. The connection element is in electrical contact with the cable conductor and can be mechanically and electrically connected to the bushing, e.g. via a threaded stud accessible through an opposed rear cavity of the separable connector. After installation, the rear cavity is filled by installing in it a so-called insulation plug, which insulates the connection element. Many insulation plugs engage with the threaded stud by threading a high-voltage portion of the insulation plug onto the threaded stud, so that the act of threading pulls the insulation plug deeper into the rear cavity. A torque feature on the accessible low-voltage end of the insulation plug, such as a hexagonal nut, facilitates use of a wrench for threading the insulation plug onto the stud.

Elements of a voltage sensor for detecting the presence or absence of the elevated voltage of the connection element of the separable connector - and thereby the voltage of the power cable - can be integrated into the insulation plug, making the insulation plug a "sensored insulation plug". No high degree of precision in sensing the presence or absence of the elevated voltage is required for this detection. A voltage sensor of that type is described, for example, in U.S. patent US 11,262,387 B2.

Certain elements of the voltage sensor within the insulation plug are on the elevated (i.e. medium or high) voltage of the connection element. They require adequate electrical insulation in order to reduce the risk of electrical discharges between any element on a higher voltage and an element on lower voltage. Due to the strong electrical fields in the vicinity of those elements the insulating material of the plug body must be a good insulator and provide a high barrier to discharges. Any void or bubble in the insulating material may give rise to undesired partial discharges.

Embedding elements of a voltage sensor in a plug body made of a solidified casting material is a proven method of obtaining a strong, mostly void-free electrical insulation, with the added benefit of mechanical rigidity of the plug body. When manufacturing such a plug body, a liquid, viscous, insulating casting material flows around the elements of the voltage sensor in a mold, filling all available space and thus reducing the risk of formation of voids. The casting material is then caused to cure and thereby solidify. The solidified insulating material forms the body of the sensored insulation plug.

The voltage detector employs a detection electrode, embedded in the body of the insulation plug and arranged close to an element of the insulation plug on elevated voltage, as a capacitive detector. A capacitor (the "detection capacitor") is formed by the element on elevated voltage as a first electrode (the "high-voltage electrode"), and the detection electrode as an opposed second electrode, with the plug body material between these electrodes being the dielectric of the detection capacitor. The detection electrode is conductively connected to a detection contact which is externally accessible on the outer surface of the insulation plug. The detection contact can be contacted with a contact on a hotstick voltage detector, for example. The hotstick voltage detector, in turn, often contains a capacitor that forms a capacitor of a voltage divider (the "detection voltage divider") for performing the voltage detection. The hotstick voltage detector can detect if elevated voltage is present in the separable connector - and hence on the power cable - or not, and it provides a corresponding visual indication to the hotstick operator.

In certain insulation plugs the detection contact is comprised in the torque feature. Where the torque feature is, for example, a metal hex nut at the rear, low-voltage end of the sensored insulation plug, an externally accessible surface portion of the torque feature may serve as the detection contact. Since the torque feature must be externally accessible to apply torque to the insulation plug in order to install the insulation plug in the rear cavity, the detection contact can be arranged on the torque feature to be externally accessible by a contact on the hotstick. In certain insulation plugs the torque feature is electrically conductive and serves as the detection contact.

Often the torque feature is hollow and is electrically and mechanically connected to the embedded detection electrode via a rigid conductive pin ("electrode pin") bearing a thread. Upon assembly of the insulation plug the torque feature is attached to the plug body by fitting the torque feature over the electrode pin and tightening a small nut sitting on the thread of the electrode pin inside the torque feature, which pulls the bottom of the torque feature against a portion of the plug body or against a surface of a circuit board. At a later stage of the assembly of the sensored insulation plug, a viscous curable resin is poured over the circuit board to embed it in the plug body. In that assembly step, the torque feature is thus pulled against the plug body or against the circuit board by the nut on the threaded electrode pin. The curable resin is later cured and thereby hardened to form the plug body.

The present inventors have found that the rigid mechanical connection between the torque feature and the detection electrode can cause a problem: when the nut is threaded tightly down the electrode pin to pull the torque feature against the plug body and the circuit board, this threading exerts a strong axial pull on the detection electrode towards the torque feature. Eventually, due to the pull, the embedded detection electrode oftentimes delaminates from the surrounding material of the plug body and creates a void in the plug body which can cause partial discharge during operation of the insulation plug, making the insulation plug less reliable.

In an attempt to address this problem, the present disclosure provides a sensored insulation plug for being installed in a rear cavity of a medium-voltage or high-voltage separable connector in a power distribution network and operable to insulate a connection element of the separable connector on an elevated voltage and to detect the elevated voltage, the sensored insulation plug comprising:
a) a plug body, rotationally symmetric about a plug axis and having a low-voltage end portion and an opposed high-voltage end portion, arranged in the vicinity of the connection element when the sensored insulation plug is installed in the rear cavity, the plug axis defining axial directions parallel to the plug axis and radial directions orthogonal thereto,
b) a detection electrode embedded in the plug body, such that the detection electrode is held on a detection voltage when the connection element is on high or medium voltage,
c) a conductive torque feature, arranged at the low-voltage end portion of the plug body such as to be externally accessible, for threading the sensored insulation plug into the separable connector, wherein the torque feature comprises a detection contact for facilitating picking up the detection voltage by a hotstick,
wherein the detection electrode and the detection contact are conductively connected via a conductive element, such that the detection contact is held on the detection voltage, characterized in that the conductive element is elastically compressible and has a spring constant of less than 2000 Newton/meter for its axial elastic compression.

The sensored insulation plug according to the present disclosure addresses the issue of partial discharge caused by the mechanical forces and moments applied to the detection electrode. By utilizing a mechanically "weak" conductive element, such as a spring, to electrically connect the torque feature to the detection electrode, the design ensures that mechanical loads are not transferred from the torque feature to the detection electrode. According to the present disclosure this conductive element has a low spring constant of less than 2000 N/m, thereby preventing movement and local delamination of the detection electrode within the plug body. According to the present disclosure, the torque feature is mechanically connected to the plug body not through the conductive element, but in other ways. It may be connected, for example, via a circuit board. In such a scenario the torque feature is attached to a major surface of the circuit board, for example by screws. The circuit board, in turn, is connected to the plug body by being embedded in the plug body, for example by surface contact with the material of the plug body, or by other suitable means, such as by apertures in the circuit board engaging with protrusions in the plug body.

In a sensored insulation plug according to the present disclosure, the major mechanical loads, in particular torque and axial forces, are transmitted from the torque feature into the plug body by way of an embedded circuit board, or, if present, by a torque bar and the circuit board. The detection electrode and the electrode pin are largely mechanically decoupled from the torque feature, with only the - mechanically relatively weak - conductive element providing an electrical connection between the detection electrode and the detection contact on the torque feature. This mechanical decoupling ensures the stability and integrity of the detection electrode and thereby reduces the risk of partial discharges associated with previous rigid mechanical connection, ensuring reliable operation of the sensored insulation plug.

The present disclosure relates to voltage sensing devices for use in medium-voltage or high-voltage power distribution networks in which electrical power is distributed over large geographic areas via HV/MV power cables, transformers, switchgears, substations etc. with currents of tens or hundreds of amperes and voltages of tens of kilovolts. The term "medium voltage" or "MV" as used herein refers to AC voltages in the range of 1 kilovolt (kV) to 72 kV, whereas the term "high voltage" or "HV" refers to AC voltages of more than 72 kV. Medium voltage and high voltage are collectively referred to herein as "elevated voltage".

Many separable connectors are T-shaped or elbow-shaped. A separable connector as referred to herein usually has a front cavity to receive a protruding portion of a bushing of the switchgear or the transformer, and an opposed rear cavity facilitating access to a connection element, such as a cable lug, on elevated voltage inside the separable connector. The connection element is conductive and is electrically and mechanically connected to the power conductor of the power cable. The connection element can be connected mechanically and electrically, e.g. by a conductive threaded stud, to a conductive element of the bushing, so that power can flow from the power cable through the connection element, the stud and the bushing into the switchgear or transformer. When the separable connector is in use, the connection element is on the elevated voltage of the power conductor of the cable.

Certain separable connectors are described in the European patent application EP 0 691 721 A1. Examples of traditional separable connectors are the 3M^{™} 600 Amp T-Bodies 5815 Series from 3M Co., St. Paul, Minnesota, U.S.A., or the "(M) (P) 480 TB separable tee shape connector" of Nexans Network Solutions N.V., Erembodegem, Belgium.

The rear cavity of a separable connector can receive a matching insulation plug to insulate the connection element and to fill the space of the rear cavity to reduce the risk of electrical discharges. Such matching pairs of separable connector and insulation plug are commercially available. In many cases, the mechanical interface between a separable connector and an insulation plug is governed by de-facto standards. Many of such interfaces conform to an existing standard for bushings, some form a Type C interface as described in the German standards DIN EN 50180 for bushings and DIN EN 50181 for plug-in type bushings, others conform to IEEE standard 386. Often, bodies of insulation plugs are slightly larger than the rear cavity, so that after the insulation plug is urged into the rear cavity with some force, the surfaces of plug and cavity are in an intimate surface contact, thus reducing the risk of electrical discharges.

A connection element of a separable connector is electrically connected to the conductor of the power cable terminated by the separable connector and is on elevated voltage when the cable is in use.

Some separable connectors comprise a connection element such as a cable lug, attached to the end of the central conductor of the power cable and protruding into a space between the front cavity and the rear cavity. The protruding portion of the connection element usually has an aperture or a thread for attachment to a stud or screw which connects the connection element electrically and mechanically, e.g. with a conductor of a bushing.

The connection element of the separable connector engages with a conductive contact piece on the sensored insulation plug. The connection element and the contact piece are electrically connected, so that in use the contact piece is on the elevated voltage of the connection element. The contact piece is, or comprises, the high-voltage electrode of the detection capacitor.

The expression "embedded in the plug body" as used herein refers to being surrounded completely by portions of the plug body. In particular, the detection electrode is considered embedded in the plug body if the plug body is cast or molded around the detection electrode. In a particular aspect, an element of the sensored insulation plug may be considered embedded in the plug body if a major portion, e.g. more than 90% or more than 95%, of its exterior surface is in surface contact with the material of the plug body.

The body of a sensored insulation plug according to the present disclosure is shaped for mating with a rear cavity of a separable connector in the same way as the body of a traditional insulation plug. The plug body may be rotationally symmetric about a plug axis. The body of the sensored insulation plug may, for example, have a frustoconical shape for being installed in a corresponding frustoconical recess of corresponding shape (the rear cavity) at a rear side of the separable connector, thereby mating the sensored insulation plug with the separable connector.

The plug body may have a generally rotationally symmetric outer shape. In order to be usable with many existing separable connectors the plug body may have a generally frustoconical outer shape, such that it can fill a frustoconical rear cavity of a separable connector without leaving too many or too large voids between the inner surface of the rear cavity and the outer surface of the plug body. The outer shape of the sensored insulation plug according to the present disclosure may be generally symmetric about a plug axis, e.g. rotationally symmetric about a plug axis. The plug axis may be an axis which is parallel to a design insertion direction, i.e. a direction in which the sensored insulation plug, by design, is supposed to be inserted into a separable connector for installation in the rear cavity. The plug axis defines axial directions, which are directions parallel to the plug axis, and radial directions, which are directions orthogonal to the axial directions.

In certain embodiments of the sensored insulation plug described herein, the torque feature, the detection contact, and the conductive element are arranged coaxially with each other on the plug axis. The coaxial arrangement of the torque feature, detection contact, and conductive element along the plug axis helps ensure a more uniform distribution of mechanical stresses during installation, thereby enhancing the structural integrity and reliability of the sensored insulation plug.

In axial directions the sensored insulation plug and the plug body comprise a high-voltage end portion and, at an opposite end in axial directions, an opposed low-voltage end portion. The high-voltage end portion is close to the connection element of the separable connector once the sensored insulation plug is installed in the rear cavity of the sensored insulation plug. Where the sensored insulation plug is frustoconical, the high-voltage end portion is the smaller-diameter end portion, while the low-voltage end portion is the larger-diameter end portion, which normally protrudes from the rear cavity when the sensored insulation plug is installed. The low-voltage end portion may have an axial end face. The axial end face of the low-voltage end portion may be oriented orthogonally to the plug axis and faces away from the detection electrode and - if present - from the contact piece of the sensored insulation plug.

At its low-voltage end portion the sensored insulation plug has a torque feature. The torque feature may have a hexagonal section or a section of any other shape that permits applying a sufficient amount of torque to the sensored insulation plug for threading it into the rear cavity. It may protrude from the plug body axially such that it can be engaged by a wrench. The torque feature facilitates applying torque to turn the sensored insulation plug about the plug axis and thereby to engage it with the connection element of the separable connector. The torque feature may be arranged symmetrically around the plug axis. Where the torque feature comprises a polygonal shape, the centre of the polygonal shape may be arranged on the plug axis.

In certain advantageous embodiments the torque feature comprises a hex nut made of a conductive metal.

In certain embodiments the torque feature comprises one or more internal threads for attaching the torque feature to a major surface of a circuit board or to a torque enhancer.

The torque feature comprises the detection contact. The detection contact is externally accessible, e.g. accessible for electrical contact of a hotstick contact. The detection contact may be externally accessible, e.g. accessible for electrical contact of a hotstick contact, after removal of a detection contact cover. The detection contact may be arranged at an outer surface of the torque feature, e.g. at an axial end face of the torque feature, where it is particularly easy to access it externally, e.g. to contact it by a hotstick. Hence in certain embodiments the detection contact is arranged at an axial end face of the torque feature.

Where the sensored insulation plug is rotationally symmetric, the detection contact may be arranged on the plug axis or close to the plug axis. The detection contact may be circular or annular, for example. A circular or annular detection contact may be arranged symmetrically around the plug axis.

The torque feature is arranged at the low-voltage end portion of the plug body. The torque feature may be arranged centered about the plug axis. In certain preferred embodiments the torque feature is rotationally symmetric about a torque feature axis, and the torque feature axis is parallel or collinear with the plug axis.

The torque feature is electrically conductive. The torque feature may comprise a conductive metal, or it may be made of a conductive metal, such as steel, copper, zinc, nickel, or aluminium. It may comprise, or be made of, alloys comprising a conductive metal. Alternatively, the torque feature may comprise a conductive polymer, or it may be made of a conductive polymer.

A function of the torque feature is to receive torque exerted by an installer, e.g. via a wrench, and to conduct the torque into the plug body so that the plug body is turned about the plug axis and thereby threaded deeper into the rear cavity of the separable connector.

The sensored insulation plug may comprise a circuit board ("PCB") for carrying electrical and electronic components, such as components of a voltage sensing circuit or of a voltage detection circuit. The PCB may be embedded in the plug body and directly mechanically connected to the plug body such as to be in surface contact with the plug body.

The mechanical connection of the torque feature to the plug body via a circuit board may be sufficiently strong to conduct torque from the torque feature into the plug body. To make the connection stronger, a torque enhancer, such as a torque bar, can be employed in addition, the torque enhancer being attached to the torque feature and/or to the circuit board. The torque enhancer may be embedded in the plug body. It may have a major surface attached to the major surface of the circuit board. This arrangement helps reinforce the circuit board, so that the combination of circuit board and torque enhancer can conduct more torque from the torque feature into the plug body than the circuit board alone can transmit. The material of the torque enhancer is not critical, as long as the torque enhancer can reinforce the circuit board against deformation or fracture caused by torque. In certain embodiments the torque enhancer comprises a segment of a printed circuit board made from a glass-fibre reinforced resinous material, such as FR-4. This is particularly cost-effective. In other embodiments the torque enhancer comprises a rigid metal sheet. The metal sheet may have a thickness of between 0.2 mm and 5 mm, for example. The metal sheet may be encapsulated in an electrically nonconductive envelope.

The torque enhancer may be directly mechanically connected to the plug body such as to be in surface contact with the plug body. Alternatively, or in addition, the torque enhancer may be indirectly mechanically connected to the plug body via the circuit board.

Hence generally, in certain embodiments the sensored insulation plug according to the present disclosure further comprises a torque enhancer, mechanically connected to the torque feature and to the circuit board to reinforce the circuit board such that more torque can be transmitted from the torque feature into the circuit board. The inclusion of a torque enhancer mechanically connected to both the torque feature and the circuit board significantly increases the amount of torque that can be transmitted from the torque feature into the circuit board, thereby enhancing the mechanical stability and reliability of the sensored insulation plug during installation.

In certain embodiments the torque enhancer is a rigid torque bar, mechanically directly connected to the torque feature. The torque enhancer may be directly mechanically connected to the circuit board embedded in the plug body such as to be in surface contact with a major surface of the circuit board.

In certain embodiments the torque feature is a hexagonal nut or "hex nut", made of steel. In certain of these embodiments, the hex nut is directly mechanically connected to a torque enhancer, namely a metal torque bar. The torque enhancer is indirectly mechanically connected to the plug body via a circuit board embedded in the plug body, which is in surface contact with an inner surface of the plug body.

The mechanical connection of the torque enhancer to the PCB may be effected by screws or soldering or other suitable means. External torque is thus transmitted from the torque feature into the torque enhancer and into the PCB, from where it is transmitted into the plug body.

The conductive element establishes an electrical connection between the detection electrode and the detection contact while minimizing the transmission of mechanical forces.

In one embodiment, the conductive element is a conductive spring, which provides the necessary electrical conductivity while transmitting only minimal mechanical forces and thus facilitating mechanical decoupling. This spring can be made from materials such as, for example, beryllium copper, phosphor bronze, or stainless steel, chosen for their electrical conductivity, mechanical resilience, and resistance to corrosion. A spring-like nature of the conductive element allows it to maintain a stable electrical connection while accommodating any slight movements or vibrations, thereby enhancing the durability and performance of the sensored insulation plug in a power distribution network.

The conductive element is configured to transmit only a small axial force, such as an axial force of less than 20 Newtons, between the torque feature and the detection electrode for expansion or compression by less than 10 miilimeters. This may help reduce mechanical stress transferred to the detection electrode, which in turn ensures the integrity and reliability of the electrical connection, even under varying mechanical loads.

The conductive element connects the detection electrode and the detection contact with each other conductively. As this conductive connection may also form a mechanical connection between the detection electrode and the detection contact on the torque feature, it is important that the conductive element is adapted to transmit only small axial forces from the torque feature to the detection electrode. Therefore, the conductive element is elastic and has a spring constant of less than 2000 Newton/meter for its axial elastic compression. In certain embodiments it has a spring constant of less than 1000 Newton/meter for its axial elastic compression.

The elasticity of the conductive element ensures that relative movement of the torque feature with respect to the detection electrode in axial direction, such as movement caused by thermal expansion or thermal contraction or mechanical shock, does not exert major axial forces on the detection electrode.

During installation and operation, including during threading of the sensored insulation plug into the rear cavity by applying external torque to the torque feature, the torque feature does not change its position relative to the detection electrode. Very small relative movements with expected amplitudes of much less than one millimeter may occur as a result of thermal effects or shock. The comparatively low spring constant limits the axial forces on the detection electrode to less than two Newton when such relative movement occurs. Under small axial forces like this, the detection electrode will generally not delaminate from the material of the plug body in which it is embedded.

The conductive element may take various different forms. In certain embodiments the conductive element is a spring. One end of the spring is electrically and mechanically connected to the detection electrode, while the opposed end is electrically connected to the detection contact and is mechanically connected to the torque feature.

The spring may take various different forms. In certain of these embodiments the spring is a coil spring. Many coil springs generally define a cylindrical outer envelope and have opposed ends. One end of the coil spring is electrically and mechanically connected to the detection electrode, while the opposed end is electrically connected to the detection contact and is mechanically connected to the torque feature.

In certain embodiments the conductive element is an elastic wire. One end of the wire is electrically and mechanically connected to the detection electrode, while the opposed end is electrically connected to the detection contact and is mechanically connected to the torque feature. Depending on its shape and arrangement, the elastic wire can transmit some small axial forces from the torque feature to the detection electrode. These axial forces could be measured to determine a spring constant of the wire in its shape and arrangement in the sensored insulation plug.

In certain embodiments the conductive element is a non-elastic wire, i.e. a wire that deforms plastically under mechanical loads. Plastic deformation is deemed to occur when loads exceed the elastic regime of the wire. To determine the spring constant of the wire, the elasticity of the wire should be determined in the elastic regime.

In certain embodiments the conductive element is adapted to transmit torque of less than one Newton Meter (1 Nm) from the torque feature to the detection electrode. This limitation helps prevent transmission of mechanical forces (like torque) from the torque feature into the detection electrode, thus reducing the risk of the detection electrode moving in the insulating material of the plug body and creating voids. In certain preferred embodiments the conductive element is adapted to transmit torque of less than 0.1 Newton meter (0.1 Nm) from the torque feature to the detection electrode.

In certain embodiments the conductive element comprises a first contact portion in surface contact with a contact surface of the torque feature. The surface contact forms a simple, yet reliable electrical connection of the conductive element with the torque feature. This simple electrical connection can even cope with certain effects of thermal expansion or contraction, as the first contact portion may slide over the contact surface of the torque feature when these elements move - or contract or expand at different rates - relative to each other.

Where the conductive element is a coil spring, the first contact portion may be an end portion of the spring. Alternatively, or in addition, middle portions of the coil spring may be in surface contact with a surface of the torque feature.

In certain embodiments, the contact surface of the torque feature is an inward-facing surface of the torque feature. An inward-facing surface is a surface which faces a central axis of the torque feature, or which faces a center of gravity of the torque feature. To illustrate this, it may be helpful to think of a hollow cylinder, where an inward-facing surface is the inner surface of the hollow cylinder. This inner surface faces the symmetry axis of the cylinder. Where the torque feature forms a cavity, a surface delimiting the cavity is usually an inward-facing surface.

It may be beneficial for the contact surface of the torque feature to be an inward-facing surface, because the body of the torque feature, enveloping the inward-facing surface, can protect the surface contact between the conductive element and the torque feature against mechanical and environmental impacts and against accidental damage done by the installer during installation. The electrical connection between the conductive element and the torque feature and the detection contact can thereby be better protected and hence more reliable.

The shape of the plug body may generally determine the outer shape of the sensored insulation plug. For durability and for reliable functioning over years it is desirable that the plug body is mechanically rigid, has a high dielectric strength, has little variation of its relative permittivity with changes in temperature over the operating temperature range, does not absorb water, and does not age. Therefore, in certain embodiments, the plug body is formed from one or more electrically insulating materials, such as from one or more hardened curable resin(s). The, or each, insulating material may be a solidified electrically insulating material.

An insulating material of the one or more insulating material(s) may be liquid during the manufacturing of the plug body and solidifies thereafter to form a rigid plug body or a portion thereof. Solidification may be obtained by curing, hardening, crosslinking, or in other known manners. An insulating material may be, for example, a solidifiable, e.g. a hardenable or curable, liquid epoxy resin or a solidifiable, e.g. hardenable or curable, liquid mixture of an epoxy resin with other materials, such as fillers, or a solidifiable, e.g. hardenable or curable, polyurethane resin or a solidifiable, e.g. hardenable or curable, mixture of a polyurethane resin with other materials, such as fillers. Useful fillers are, for example, SiO₂ or Al₂O₃ or other electrically insulating inorganic materials. Alternatively, an insulating material may be or may comprise, for example, a ceramic material.

In certain embodiments an insulating material forming the plug body comprises an epoxy resin and, optionally, a filler, such as SiO₂ or Al₂O₃ or another electrically insulating inorganic material. Epoxy resins provide high electrical withstand, and much knowledge exists around molding or casting epoxy resins, furthermore these resins are available at moderate cost. Suitable fillers can help increase electrical withstand of an insulation material or to reduce its shrinkage upon solidifying. Where an insulation material is used as a dielectric in a capacitor, e.g. in the detection capacitor, choosing a suitable filler may allow to adjust the coefficient of thermal expansion of the insulation material and thereby the variation of the capacitance of the capacitor with temperature.

In certain embodiments the sensored insulation plug further comprises a rigid circuit board, embedded in the plug body and comprising a major surface and conductive traces on the major surface for connecting electric and electronic components on the circuit board.

The rigid circuit board embedded within the plug body may provide additional mechanical support and stability to the overall structure of the sensored insulation plug. This reinforcement helps to maintain the shape and integrity of the plug body, especially under mechanical stresses such as torque during installation. The conductive traces on the circuit board facilitate reliable electrical connections between various electric and electronic components. This ensures that the voltage sensing and detection circuits function accurately and consistently, contributing to the overall reliability of the voltage detection feature.

Embedding the circuit board within the insulating material of the plug body protects the electric and electronic components from environmental factors such as moisture, dust, and mechanical impact. This protection enhances the durability and longevity of the components, ensuring stable operation over time. The integration of the circuit board within the plug body allows for a more compact and streamlined design. This reduces the overall size of the sensored insulation plug, making it easier to handle and install in confined spaces within medium-voltage and high-voltage power distribution networks.

The use of a circuit board with conductive traces simplifies the assembly process by providing a standardized platform for mounting and connecting components. This modular approach can reduce manufacturing complexity and costs, while also facilitating easier maintenance and replacement of components in the field.

The circuit board can also aid in thermal management by providing a pathway for heat dissipation from the electric and electronic components. This helps to prevent overheating and ensures that the components operate within their optimal temperature range.

In certain embodiments the torque feature is in surface contact with a major surface of the circuit board and is firmly attached to the circuit board to transmit torque from the torque feature into the plug body. By ensuring that the torque feature is in surface contact with a major surface of the circuit board and is firmly attached to the circuit board, the design facilitates the efficient transmission of torque from the torque feature into the plug body. This configuration offers the following technical advantages. In particular, the firm attachment of the torque feature to the circuit board ensures that the mechanical loads, particularly torque, are evenly distributed across the circuit board and subsequently into the plug body. This reduces the risk of mechanical failure or deformation of the plug body during installation and operation.

Also, the surface contact between the torque feature and the major surface of the circuit board provides a robust mechanical interface that can effectively transmit the applied torque. This ensures that the sensored insulation plug can be securely threaded into the separable connector, maintaining a reliable electrical connection. The robust mechanical connection between the torque feature and the circuit board contributes to the overall durability and longevity of the sensored insulation plug. The design ensures that the plug can withstand repeated installations and removals without compromising its structural integrity or electrical performance.

In certain embodiments the circuit board comprises protrusions protruding from a major surface of the circuit board for transmitting torque from the circuit board into the plug body. The protrusions may be in surface contact with the insulating material in which the circuit board is embedded. The protrusions may assist in effectively transmitting torque from the circuit board into the plug body, thereby enhancing the mechanical stability and ensuring a secure and reliable installation of the sensored insulation plug in the rear cavity of the separable connector as the sensored insulation plug is threaded on the conductive stud of the connector.

In some embodiments, the protrusions are fins, such as flat fins. In other embodiments, the protrusions are cylindrical protrusions.

As an alternative to protrusions of the circuit board, axially-extending pins ("torque pins") or screws ("torque screws") may be embedded in the plug body which extend through apertures in the circuit board and engage with those apertures. Torque can thereby be transmitted from the circuit board into the plug body via the pins or screws. Hence, generally, the sensored insulation plug may comprise elongated torque pins or torque screws, at least partially embedded in the plug body and extending lengthwise in axial directions through respective apertures in the circuit board, for transmitting torque from the circuit board into the plug body.

In certain embodiments the torque feature is firmly attached to the circuit board by two or more screws, or by an adhesive material. The use of screws to attach the torque feature to the circuit board simplifies the assembly process and allows for easier maintenance or replacement of components. This modular approach can reduce manufacturing costs and improve serviceability in the field. Attaching the torque feature by an adhesive provides for an attachment that can save space in the interior of the sensored insulation plug and can help reduce its weight.

In certain embodiments the detection electrode is a first electrode of a detection capacitor, wherein the second electrode of the detection capacitor is a high-voltage electrode comprised in a contact piece of the sensored insulation plug for mechanical and electrical connection to the connection element, and wherein a dielectric of the detection capacitor comprises a portion of an insulating material forming the plug body.

The detection capacitor is formed by structural elements, such as the contact piece, the insulation material, and the detection electrode) of the sensored insulation plug. This may be beneficial because the arrangement and formation of the electrodes and of the dielectric may contribute to a rugged, compact and integrated design that enhances the reliability and accuracy of voltage detection while minimizing the risk of partial discharges and mechanical failures. A portion of the contact piece forming the second electrode makes the provision and assembly of a dedicated separate additional electrode obsolete.

As used in this disclosure, an integrated capacitor is a capacitor that is formed by structural elements of the sensored insulation plug. In contrast to an integrated capacitor, a discrete capacitor is a separate, individual electrical device that exists independently from the structural elements of the sensored insulation plug. A surface-mount capacitor is an example of a discrete capacitor. In certain embodiments the detection capacitor is an integrated capacitor.

The use of an integrated detection capacitor may be beneficial because of its reliability in medium- and high-voltage environments. The adequate geometric distance between its electrodes can be chosen more freely in dependence from the use case, and a suitable electrical insulation material can be chosen to form the dielectric. An integrated detection capacitor may also bring cost advantages, since discrete capacitors for the high- and medium voltage regime tend to be expensive.

In normal operation of the sensored insulation plug and of the separable connector the detection contact of the torque feature is supposed to be on electrical ground. This is usually achieved by covering the torque feature with a cap of conductive rubber. This conductive cap electrically connects the detection contact and the entire torque feature with an element of the separable connector on electrical ground, directly or via an intermediate conductive component. When the presence or absence of elevated voltage is to be detected, the conductive cap is removed from the detection contact so that the grounding is removed, and the detection contact is on the detection voltage. A hotstick can pick up the detection voltage from the detection contact. The conductive cap also provides protection of the detection contact and of the entire torque feature against mechanical and environmental effects as well as it provides a certain electrical shielding.

Certain standards require that, in a wide temperature range, the force necessary to remove the conductive cap is within a defined interval, such as between 36 Newton (N) and 210 N for temperatures between -20°C and +65°C according to the current standard IEEE 386. However, if a conductive rubber cap engages with the torque feature mechanically in traditional ways by deformation of the conductive cap, the removal force is dependent on the temperature and on the rubber formulation.

In an attempt to make the required removal force less dependent on the temperature, the torque feature can comprise a ferromagnetic material, and the conductive cap comprises a magnet in a suitable location, such as close to its inner surface. The present disclosure thus also provides a conductive cap, for being held in surface contact with the torque feature and for covering the torque feature, the cap being operable to electrically ground the torque feature, wherein the torque feature comprises a ferromagnetic material, and wherein the conductive cap comprises a magnet, arranged close enough to the torque feature to attract the torque feature with a strength sufficient to hold the conductive cap in surface contact with the torque feature when the conductive cap covers the torque feature.

The torque feature may be made of, or comprise, steel, or iron, cobalt, nickel, or neodymium, or their alloys, or any other ferromagnetic material. The magnet may be made of, or comprise, steel, or iron, cobalt, nickel, or neodymium, or their alloys, or any other suitable ferromagnetic material.

In a preferred embodiment, the torque feature is made of steel, and the conductive cap is conductive rubber cap and comprises a magnet comprising neodymium.

Hence in certain embodiments of the sensored insulation plug according to the present disclosure, the sensored insulation plug further comprises a conductive cap, held in surface contact with the torque feature and covering the torque feature, the cap being operable to electrically ground the torque feature, wherein the torque feature comprises a ferromagnetic material, and wherein the conductive cap comprises a magnet, arranged close enough to the torque feature to attract the torque feature with a strength sufficient to hold the conductive cap in surface contact with the torque feature.

In certain scenarios a conductive cap may be supposed to be held ono the torque feature by non-magnetic means, such as when the torque feature is not ferromagnetic. In such embodiments a mechanical engagement of the conductive cap and the torque feature may be desirable, such as by deformation of the conductive cap and a mechanical engagement between protrusions on the cap and recesses in the torque feature, or vice versa. To engage a given cap with a variety of differently shaped torque features, a mechanical adapter may be used. Such an adapter may take the form of a ring with protrusions that snap-fit into corresponding recesses in the outer surface of the torque feature, and an annular recess into which a corresponding annular protrusion on an inner surface of the conductive cap may snap.

In a second aspect, the present disclosure provides a power network comprising a separable connector comprising a rear cavity, a connection element on elevated voltage, and a sensored insulation plug as described herein, wherein the sensored insulation plug is installed in the rear cavity, and wherein a detection voltage on the detection contact indicates a presence or absence of the elevated voltage on the connection element. The enhanced reliability of the sensored insulation plug according to the present disclosure helps make the entire power network more reliable and more cost-effective to maintain.

In a third aspect, the present disclosure provides a method of installing a sensored insulation plug as described herein in a rear cavity of a separable connector, the method comprising applying torque to the torque feature to thread the sensored insulation plug onto a connection stud of the separable connector. This method generally results in a more reliable connection of a power cable to an electrical apparatus like a transformer or a switchgear, as the mechanical forces transmitted to the detection electrode during manufacturing of the sensored insulation plug are reduced and the detection electrode remains in surface contact with the insulation material in which it is embedded. The risk of creating voids during manufacturing is thus lower, and the resulting sensored insulation plug is therefore more reliable than traditional sensored insulation plugs.

The sensored insulation plug of the present disclosure will now be described in more detail with reference to the following Figures:
- Fig. 1: Sectional view of a separable connector and a first sensored insulation plug according to the present disclosure,
- Fig. 2: Sectional view of the first sensored insulation plug of Figure 1, and
- Fig. 3: Sectional view of a second sensored insulation plug having a torque enhancer.

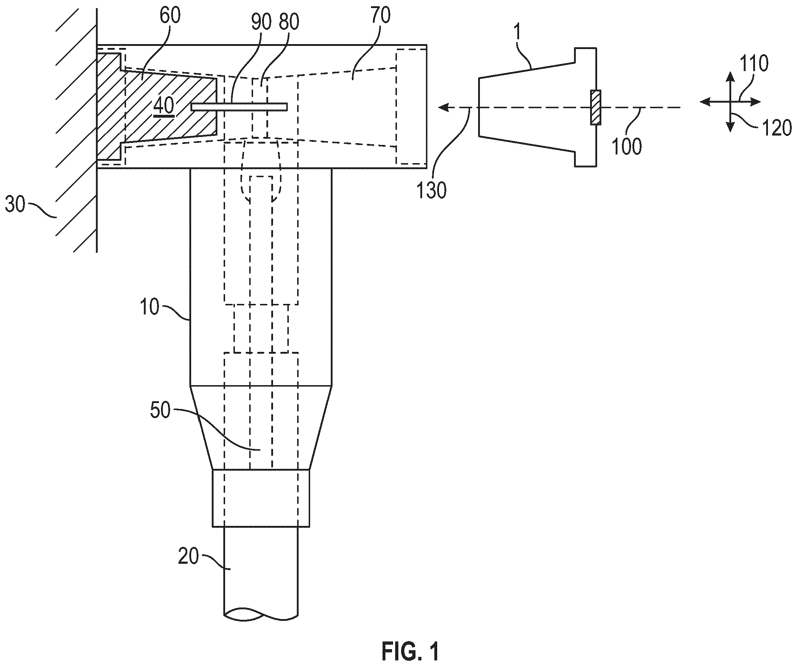

The sectional view of Figure 1 illustrates a medium-voltage separable connector 10 and generally a first sensored insulation plug 1 according to the present disclosure. The separable connector 10 is arranged at an end of a medium-voltage power cable 20 and connects, via a bushing 40, the power-carrying central conductor 50 of the cable 20 to a medium-voltage switchgear 30 in a power distribution network of a national grid.

The separable connector 10 is a T-shaped separable connector 10 and comprises a front cavity 60 for receiving the bushing 40, and a rear cavity 70 for receiving an insulation plug 1 of a matching shape according to the present disclosure, shown schematically in Figure 1 to the right of the rear cavity 70, before being installed in the rear cavity 70. The insulation plug 1 according to the present disclosure serves to electrically insulate a cable lug 80 of the separable connector 10, which is electrically connected to the central conductor 50 of the cable 20 and can be electrically and mechanically connected to a conductive component of the bushing 40 via an electrically conductive, threaded connection stud 90. In use, the cable lug 80 is on the elevated voltage of the central conductor 50 of the cable.

The first sensored insulation plug 1 has an overall frustoconical outer shape, generally rotationally symmetric about a plug axis 100 which defines axial directions 110 and radial directions 120, which are directions orthogonal to the axial directions 110. The sensored insulation plug 1 can be inserted into the rear cavity 70 by moving it axially in an axial insertion direction 130 into the rear cavity 70 where it is turned by several revolutions about the plug axis 100 so that it threadedly engages with the connection stud 90 on elevated voltage. The geometry of the insulation plug 1 is adapted to conform to IEEE standard 386 to be suitable for a greater number of separable connectors. Depending on where the insulation plug 1 is to be used, it could alternatively be adapted to conform to other standards or be adapted to fit into the most common types of separable connectors in a specific area of the world.

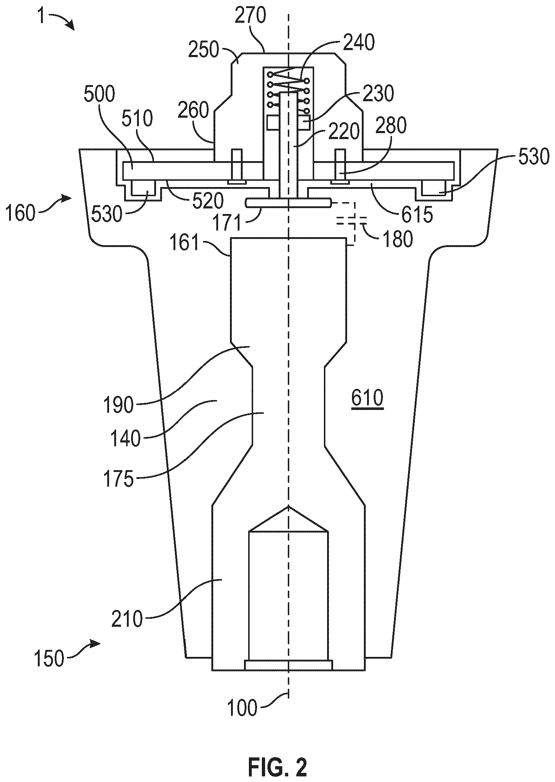

The sectional view of Figure 2 illustrates the first sensored insulation plug 1 according to the present disclosure in more detail. The sensored insulation plug 1 includes a plug body 140 formed by a first solidified insulating material 610 and a second solidified insulating material 615. The plug body 140 is rotationally symmetric about the axis 100. Its high-voltage end portion 150 is arranged deep in the rear cavity 70, once the insulation plug 1 is fully inserted and installed, and its opposed low-voltage end portion 160 protrudes from the rear cavity 70 even when the insulation plug 1 is completely installed.

A conductive contact piece 175 is embedded in the plug body 140. It comprises an engagement portion 210 for mechanical engagement and electrical connection with the connection element 80 of the separable connector 10. In use, the contact piece 175 is thus on the elevated voltage of the connection element 80. The contact piece 175 is generally rotationally symmetric about the plug axis 100. It has an electrode portion 190 forming a high-voltage electrode 161. The engagement portion 210 and the electrode portion 190 are formed as a single piece of metal.

The insulation plug 1 comprises a flat detection electrode 171 which is embedded in the plug body 140 and arranged opposite to the high-voltage electrode 161. The high-voltage electrode 161 and the detection electrode 171 form a detection capacitor 180, with a portion of the insulating material 610 of the plug body 140 forming the dielectric of the detection capacitor 180. The detection electrode 171 is on a certain voltage, the "detection voltage", when the high-voltage electrode 161 is on the elevated voltage of the power cable 20. The detection voltage varies with the elevated voltage, and it is indicative of the presence or absence of an elevated voltage in the high-voltage electrode 161 and in the connection element 80 of the separable connector 10.

To make the detection voltage available at a detection contact, the detection electrode 171 is provided with a threaded electrode pin 220, protruding axially from the detection electrode 171. A conductive nut 230 sits on the thread of the electrode pin 220 and supports the bottom end of a coil spring 240 of conductive metal. The top end of the coil spring 240 is in electrical and mechanical contact with a surface portion of an electrically conductive torque feature 250.

The torque feature 250 is arranged at the low-voltage end portion 160 of the plug body such 140 and is externally accessible. External torque can be applied to it, such as by a wrench, to thread the sensored insulation plug 1 into the separable connector 10. The torque feature 250 comprises an axial section, the "hexagonal section" 260, having a hexagonal cross section to facilitate engagement with a wrench.

At its top end, a surface portion of the torque feature 250 forms a detection contact 270 at which the detection voltage of the detection electrode 171 can be picked up, for example by a hotstick. The detection electrode 171 and the detection contact 270 are conductively connected via the conductive body of the torque feature 250, the conductive coil spring 240 contacting a surface of the torque feature 250, the conductive nut 230 supporting the coil spring 240, and the electrode pin 220, which is conductively connected to the detection electrode 171. The detection contact 270 is thus held on the detection voltage.

The coil spring 240 is a conductive element 240 which is elastic. It is selected to have a spring constant of less than 2000 Newton per meter, so that it does not transmit mechanical forces like torque or axial forces from the torque feature 250 into the detection electrode 171.

During assembly, the axial position of the nut 230 is adjusted such that the coil spring 240 is slightly compressed between the torque feature 250 and the nut 240 in order to be in a reliable surface contact with both the nut 240 and the torque feature 250, thereby ensuring an adequate electrical contact between these two elements. This pre-compression is adjusted to exert axial forces of less than one Newton on the detection electrode 171. The low spring constant of the coil spring 240 results in only small (typically < 1N) additional axial forces being exerted on the detection electrode 171 when the sensored insulation plug 1 experiences thermal contraction or mechanical shock.

The sensored insulation plug 1 further comprises a flat, rigid circuit board 500 of generally annular shape, arranged concentrically with the plug axis 100. The circuit board 500 comprises conductive traces by which electric and electronic components (not shown) arranged on the upper surface 510 and on the lower surface 520 of the circuit board 500, are electrically connected with each other. The circuit board 500 and the components on its surfaces are embedded in the second insulating material 615 forming a portion of the plug body 140.

The torque feature 250 is in surface contact with the upper surface 510 of the circuit board 500 and is firmly attached to the circuit board 500 by a plurality of screws 280. An external torque about the axis 100 applied to the torque feature 250 is thus transmitted into the circuit board 500 and - by virtue of the circuit board 500 being embedded in the plug body 140 - further into the plug body 140, so that the plug body 140 and the entire sensored insulation plug 1 can be threaded onto the conductive connection stud 90 in the separable connector 10.

To facilitate and enhance the transfer of torque from the circuit board 500 into the plug body 140, the circuit board 500 comprises fins 530 that protrude orthogonally from the lower major surface 520 of the circuit board 500. The fins 530 help anchor the circuit board 500 in the second solidified insulating material 615 of the plug body 140 in which the entire circuit board 500 is embedded, so that the circuit board 500 is less likely to "slip" within the second insulation material 615.

Instead of flat fins 530, other shapes of protrusions 530 may be used, such as protrusions 530 having a cylindrical or cubical shape. Such protrusions 530 may be arranged on the upper major surface 510 and/or on the lower major surface 520. Whatever their shape, the protrusions 530 are firmly attached to a major surface 510, 520 of the circuit board 500, so that they can assist in transferring torque from the circuit board 500 into the plug body 140.

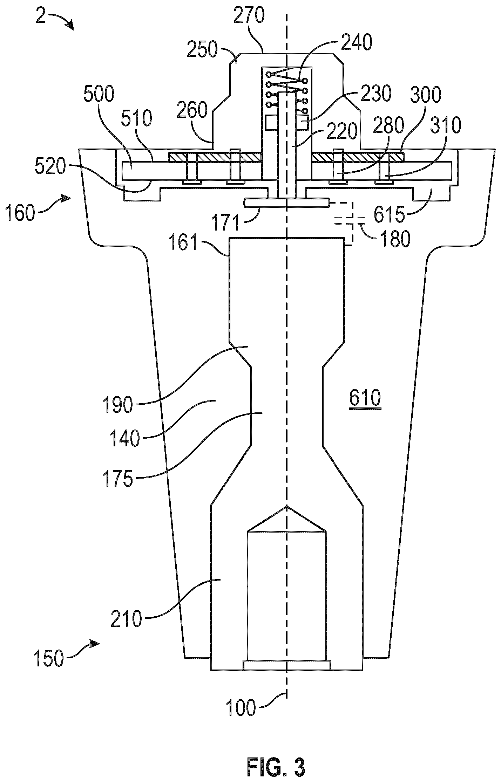

The sectional view of Figure 3 illustrates a second sensored insulation plug 2 according to the present disclosure. The second sensored insulation plug 2 is identical with the first sensored insulation plug 1, except for the addition of a torque enhancer 300. The torque enhancer 300 is a rigid, flat element, which is mechanically connected between the torque feature 250 and the circuit board 500. It reinforces the circuit board 500 so that more torque can be transmitted from the torque feature 250 into the circuit board 500.

The torque enhancer 300 is in surface contact with the upper major surface 510 of the circuit board 500, and it is firmly attached to that major surface 510 by the screws 280 that also connect the torque feature 250 with the circuit board 500, and two additional torque enhancer screws 310. The firm connection between the torque enhancer 300 and the circuit board 500 helps maintain a rugged connection between the torque enhancer 300 and the circuit board 500 over a large surface area. The torque enhancer 300 and its rugged connection to the circuit board 500 help keep the circuit board 500 intact, flat and undistorted when a considerable amount of torque is applied to it via the torque feature 250.

The torque enhancer 300 in the embodiment of Figure 3 is a segment of a printed circuit board, made from a glass-fibre reinforced resinous material, such as FR-4, for example. The torque enhancer 300 may be congruent with the upper surface 510 of the circuit board 500. Alternatively, the torque enhancer 300 may have a peripheral contour, when viewed along the surface normal of the circuit board 500, which is inside the contour of the circuit board 500.

It is contemplated that the torque enhancer 300 can be connected to the upper major surface 510 of the circuit board 500 by a layer of adhesive, instead of by the torque enhancer screws 310.

It would also be envisaged to mount the torque enhancer 300 on the bottom major surface 520 of the circuit board 500, be it with torque enhancer screws 310, with adhesive, or with any other suitable means.

## Claims

1. Sensored insulation plug (1, 2)
for being installed in a rear cavity (70) of a medium-voltage or high-voltage separable connector (10) in a power distribution network and operable to insulate a connection element (80) of the separable connector (10) on an elevated voltage and to detect the elevated voltage,
the sensored insulation plug comprising:
a) a plug body (140), rotationally symmetric about a plug axis (100) and having a low-voltage end portion (160) and an opposed high-voltage end portion (150), arranged in the vicinity of the connection element (80) when the sensored insulation plug is installed in the rear cavity (70),
the plug axis defining axial directions (110) parallel to the plug axis and radial directions (120) orthogonal thereto,
b) a detection electrode (171) embedded in the plug body (140),
such that the detection electrode is held on a detection voltage when the connection element is on high or medium voltage,
c) a conductive torque feature (250), arranged at the low-voltage end portion (160) of the plug body (140) such as to be externally accessible, for threading the sensored insulation plug (1) into the separable connector (10), wherein the torque feature (250) comprises a detection contact (270) for facilitating picking up the detection voltage by a hotstick,
wherein the detection electrode (171) and the detection contact (270) are conductively connected via a conductive element (240), such that the detection contact (270) is held on the detection voltage,
**characterized in that** the conductive element (240) is elastically compressible and has a spring constant of less than 2000 Newton/meter for its axial elastic compression.

2. Sensored insulation plug (1, 2) according to claim 1, wherein the conductive element (240) is adapted to transmit torque of less than one Newton Meter (1 Nm) from the torque feature (250) to the detection electrode (171).

3. Sensored insulation plug (1, 2) according to claim 1 or claim 2, further comprising a rigid circuit board (500), embedded in the plug body (140) and comprising a major surface (510, 520) and conductive traces on the major surface for connecting electric and electronic components on the circuit board with each other.

4. Sensored insulation plug (1, 2) according to claim 3, wherein the torque feature (250) is in surface contact with the major surface (510, 520) of the circuit board (500) and is firmly attached to the circuit board (500) to transmit torque from the torque feature (250) into the plug body (140).

5. Sensored insulation plug (1, 2) according to any one of the preceding claims, wherein the torque feature (250), the detection contact (270), and the conductive element (240) are arranged coaxially with each other on the plug axis (100).

6. Sensored insulation plug (1, 2) according to any one of the preceding claims, wherein the detection electrode (171) is a first electrode of a detection capacitor (180), and wherein the second electrode of the detection capacitor is a high-voltage electrode (161) comprised in a contact piece (175) of the sensored insulation plug for mechanical and electrical connection to the connection element (80), and wherein a dielectric of the detection capacitor (180) comprises a portion of an insulating material (610) forming the plug body (140).

7. Sensored insulation plug (1, 2) according to claim 6, wherein the detection capacitor (180) is an integrated capacitor.

8. Sensored insulation plug (2) according to any one of claims 3-7, further comprising a torque enhancer (300), mechanically connected to the torque feature (250) and to the circuit board (500) to reinforce the circuit board such that more torque can be transmitted from the torque feature (250) into the circuit board (500).

9. Sensored insulation plug (1, 2) according to any one of claims 3-8, wherein the torque feature (250) is firmly attached to the circuit board (500) by two or more screws (280), or by an adhesive material.

10. Sensored insulation plug (1, 2) according to any one of claims 3-9, wherein the circuit board (500) comprises protrusions (530) protruding from a major surface (510, 520) of the circuit board for transmitting torque from the circuit board (500) into the plug body (140).

11. Sensored insulation plug (1, 2) according to any one of the preceding claims, wherein the conductive element (240) comprises a first contact portion in surface contact with a contact surface of the torque feature (250).

12. Sensored insulation plug (1, 2) according to the preceding claim, wherein the contact surface of the torque feature (250) is an inward-facing surface of the torque feature (250).

13. Sensored insulation plug (1, 2) according to any one of the preceding claims, further comprising a conductive cap, held in surface contact with the torque feature (250) and covering the torque feature, the cap being operable to electrically ground the torque feature, wherein the torque feature comprises a ferromagnetic material, and wherein the conductive cap comprises a magnet, arranged close enough to the torque feature to attract the torque feature with a strength sufficient to hold the conductive cap in surface contact with the torque feature.

14. Power network comprising a separable connector (10) comprising a rear cavity (70), a connection element (80) on elevated voltage, and a sensored insulation plug (1, 2) according to any one of the preceding claims, wherein the sensored insulation plug is installed in the rear cavity, and wherein a detection voltage on the detection contact indicates a presence or absence of the elevated voltage on the connection element (80).

15. Method of installing a sensored insulation plug (1, 2) according to any one of claims 1-13 in a rear cavity (70) of a separable connector (10), the method comprising applying torque to the torque feature (250) to thread the sensored insulation plug (1, 2) onto a connection stud (90) of the separable connector.
